# EUROPEAN PATENT APPLICATION

(11) **EP 4 287 253 A1**
(43) Date of publication of application: **06.12.2023**
(21) Application number: 23175717.0
(22) Date of filing: 26.05.2023
(51) Int. Cl.: H01L 23/495, H01L 23/367, H01L 23/552

(54) **CHIP SCALE QFN PLASTIC PACKAGING SYSTEM FOR HIGH FREQUENCY INTEGRATED CIRCUITS**

(30) Priority: 01.06.2022 TR 202209018
(71) Applicant: Aselsan Elektronik Sanayi ve Ticaret Anonim Sirketi, 06200 Ankara (TR)
(72) Inventor: AYDOGAN, YIGIT, Ankara (TR); AKTUG, AHMET, Ankara (TR); DEGIRMENCI, AHMET, Ankara (TR)
(74) Representative: Yamankaradeniz, Kemal

(57) **Abstract**

The invention relates to a Chip-Scale QFN (Chip Scale QFN, CSQFN) plastic packaging system (1) for high frequency integrated circuits with high electrical and thermal performance, that does not use connecting wires, which are inexpensive and reliable, whose connection to PCB can be reprocessed and that are compatible with standard SMD bonding processes on PCB.

## Description

### Technical Field

The invention relates to a Chip-Scale QFN (Chip Scale QFN, CSQFN) plastic packaging system for high frequency integrated circuits with high electrical and thermal performance, that does not use connecting wires, which are inexpensive and reliable, whose connection to PCB can be reprocessed and that are compatible with standard SMD bonding processes on PCB.

### Known State of the Art

Integrated circuits are subjected to high electrical load due to operating conditions and generate waste thermal energy output. Packaging systems that offer high thermal performance are needed to ensure the use of these integrated circuits in electronic systems.

Integrated circuits whose RF and DC connections are located on the upper surface of the chip can be placed into the connections in the package with the chip rotation technique without using the connection wire, although the noise problem caused by high frequency connection wires is solved, this packaging system is insufficient in terms of thermal performance. Integrated circuits with RF and DC connections formed on the bottom surface of the chip, are applied with molded upper protection on the chip to form direct contact (hotvia) chip size packages and they can be connected on the PCB. This packaging, which solves the thermal performance problem, increases bending, cracking and breakage caused by thermal expansion coefficient incompatibility caused by large chip size classical solder assembly methods and transporting and placing the chip package, especially in applications where multifunctional and/or multi-channel chips are used, and the gaps that may occur under the connections when connecting PCB connections with classical solder assembly methods make it difficult to re-solder due to the very small direct contact connection areas. In multi-layer packaging systems, the connections of the packaging with the chip that open out of the integrated circuit are brought to the same level by means of the gap in the middle of the connection layer, and the outputs on the chip can be connected to the packaging connections with connecting wires in a way that creates low interference. Although the thermal and electrical performance of packaging increases, the size of the integrated circuit package is very large compared to the chip size, which creates a size problem due to the placement of the wavelength-limited chip size in the integrated circuit package of the chip. Even though chip-on-board applications where the chip is bonded directly to the PCB completely eliminate the thermal problem; the parasitic effects caused by connection wires, the difficulty of installation, the inability to re-establish connection, and the difficulty of applying the insulation that must be applied to the chip area to protect the chip make chip-on-board applications inappropriate in high frequency applications. In the packaging method with micro-coaxial connection, the connection wires are formed in a micro-coaxial structure, preventing the formation of interference, but the packaging size exceeds the chip size.

Considering the shortcomings of the packaging systems of high frequency integrated circuits existing in the present technique, there is a need for a Chip-Scale QFN (Chip Scale QFN, CSQFN) plastic packaging system for high frequency integrated circuits with high electrical and thermal performance, that does not use connecting wires, which are cheap and reliable, whose connection to PCB can be reprocessed and that are compatible with standard SMD bonding processes on PCB.

In the research conducted in the present technique, the application numbered CN109904125B was found. The application relates to a high temperature resistant QFN packaging preparation method. In the application, the chip is positioned on a heat dissipation layer and is connected by soldering with multiple conductive layers embedded around the heat dissipation layer; the chip, heat dissipation layer and conductive layers are coated with epoxy resin.

As a result, due to the above-mentioned problems and the inadequacy of the existing solutions on the subject, it was deemed necessary to make an improvement in the relevant technical field.

### Object of the Invention

The main object of the invention is to provide a Chip-Scale QFN (Chip Scale QFN, CSQFN) plastic packaging system for high frequency integrated circuits with high electrical and thermal performance, that does not use connecting wires, which are cheap and reliable, whose connection to PCB can be reprocessed and that are compatible with standard SMD bonding processes on PCB.

The structural and characteristic features of the invention and all its advantages will be understood more clearly by means of the figures given below and the detailed description written by making references to these figures. Therefore, the evaluation should be made by taking into account these figures and detailed description.

### Description of the Figures

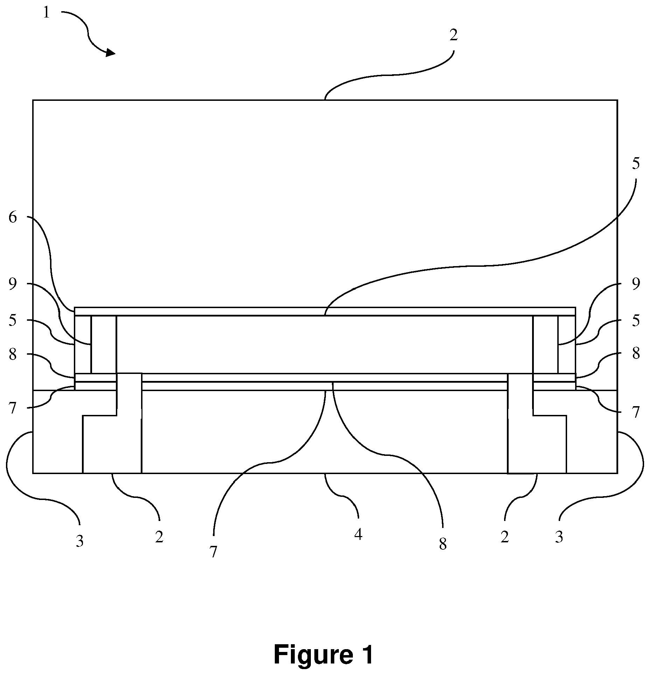

Figure 1 is a cross-sectional diagram of the system that is the subject of the invention.

### Description of Part References

1. System
2. Protective coating
3. QFN side connections
4. QFN base connection
5. Semiconductor chip
6. On-chip protective layer
7. Connection layer
8. Conductive back surface layer
9. Direct contact connection

### Detailed Description of the Invention

In this detailed description, the preferred embodiments of the invention are described only in order to better understand the subject in such a way not to create any limiting effects.

Chip-Scale QFN (Chip Scale QFN, CSQFN) plastic packaging system (1) for high frequency integrated circuits with high electrical and thermal performance, that does not use connecting wires, which are cheap and reliable, whose connection to PCB can be reprocessed and that are compatible with standard SMD bonding processes on PCB, the said system comprises the following:
- at least one protective coating (2), configured to form the outer layer of the integrated circuit package and to protect the integrated circuit against external influences;
- multiple QFN side connections (3), configured to be located on all side surfaces of the integrated circuit, to ensure the connection of RF and DC connections on the PCB to the integrated circuit;
- at least one QFN base connection (4), configured to be located on the base surface of the integrated circuit, to ensure the connection of at least one of the RF and/or DC connections on the PCB to the integrated circuit and to increase the thermal contact surface with the PCB,
- at least one semiconductor chip (5), configured to process high frequency RF signals;
- at least one on-chip protective layer (6), configured to be located on the semiconductor chip (5) and to physically protect the upper part of the semiconductor chip (5);
- at least one connection layer (7), configured to establish electrical, thermal and physical connection between the semiconductor chip (5) and the QFN packaging base;
- at least one conductive back surface layer (8), configured to establish electrical, and thermal connection between the semiconductor chip (5) and the QFN packaging base;
- multiple direct contact connections (9), configured to connect the semiconductor chip (5) to QFN side connections (3) and at least one QFN base connection (4).

The protective coating (2) in the chip-scale QFN plastic packaging system (1), which is the subject of the invention, is configured to form the outer layer of the integrated circuit package and to protect the integrated circuit against external influences.

The QFN side connections (3) in the chip-scale QFN plastic packaging system (1), which is the subject of the invention, are configured to be located on all side surfaces of the integrated circuit and to enable the connection of RF and DC connections on the PCB to the integrated circuit. In the preferred embodiment of the invention, the QFN side connections (3) are configured to connect to the semiconductor chip (5) with at least one direct contact connection (9).

The QFN base connection (4) in the chip-scale QFN plastic packaging system (1), which is the subject of the invention, is configured to be located on the base surface of the integrated circuit, to ensure the connection of at least one of the RF and/or DC connections on the PCB to the integrated circuit, to increase the thermal contact surface with the PCB. In the preferred embodiment of the invention, the QFN base connection (4) is configured to connect to the semiconductor chip (5) with at least one direct contact connection (9).

The semiconductor chip (5) in the chip-scale QFN plastic packaging system (1), which is the subject of the invention, is configured to process high frequency RF signals. In the preferred embodiment of the invention, the semiconductor chip (5) is configured to connect multiple direct contact connections (9) to multiple QFN side connections (3) and at least one QFN base connection (4).

The on-chip protective layer (6) in the chip-scale QFN plastic packaging system (1), which is the subject of the invention, is configured to be located on the semiconductor chip (5) and to physically protect the upper part of the semiconductor chip (5).

The connection layer (7) in the chip-scale QFN plastic packaging system (1), which is the subject of the invention, is configured to establish electrical, thermal and physical connection between the semiconductor chip (5) and the QFN packaging base. In the preferred embodiment of the invention, the connection layer (7) is configured to be manufactured from materials with a thermal expansion coefficient that will dampen the thermal expansion coefficient difference between the semiconductor chip (5) and the QFN packaging base.

The conductive back surface layer (8) in the chip-scale QFN plastic packaging system (1), which is the subject of the invention, is configured to establish an electrical and thermal connection between the semiconductor chip (5) and the QFN packaging base. In the preferred embodiment of the invention, the conductive back surface layer (8) is configured to mechanically support the electrical connection of the direct contact connections (9) of the semiconductor chip (5). In the preferred embodiment of the invention, the conductive back surface layer (8) is configured to facilitate the thermal energy dissipation of the semiconductor chip (5) together with the connection layer (7).

The direct contact connections (9) in the chip-scale QFN plastic packaging system (1), which is the subject of the invention, are configured to connect the semiconductor chip (5) to the QFN side connections (3) and at least one QFN base connection (4). In the preferred embodiment of the invention, the direct contact connections (9) are configured to connect the semiconductor chip (5) to the QFN side connections (3) and at least one QFN base connection (4) by creating an interface with the conductive back surface layer (8) and the connection layer (7).

### Application of the Invention to Industry

The chip-scale QFN plastic packaging system (1), which is the subject of the invention, is bonded on the base of the QFN packaging base with the conductive back surface layer (8) and the connection layer (7), the direct contact connections (9) connect the semiconductor chip (5) to the QFN side connections (3) and at least one QFN base connection (4) by creating an interface with the conductive back surface layer (8) and the connection layer (7), the on-chip protective layer (6) is located on the semiconductor chip (5) and the protective coating (2) is formed on the semiconductor chip (5) and between the QFN side connections (3) and at least one QFN base connection (4) to protect the integrated circuit package against external effects. In this way, a packaging structure is created especially for integrated circuits operating at millimeter wave frequencies with high thermal performance and suitable for SMD bonding techniques on standard PCB surface.

## Claims

1. Chip-Scale QFN (Chip Scale QFN, CSQFN) plastic packaging system (1), which is the subject of the invention, for high frequency integrated circuits with high electrical and thermal performance, that does not use connecting wires, which are cheap and reliable, whose connection to PCB can be reprocessed and that are compatible with standard SMD bonding processes on PCB, **characterized by comprising** the following
- at least one protective coating (2), configured to form the outer layer of the integrated circuit package and to protect the integrated circuit against external influences;
- multiple QFN side connections (3), configured to be located on all side surfaces of the integrated circuit, to ensure the connection of RF and DC connections on the PCB to the integrated circuit;
- at least one QFN base connection (4), configured to be located on the base surface of the integrated circuit, to ensure the connection of at least one of the RF and/or DC connections on the PCB to the integrated circuit and to increase the thermal contact surface with the PCB,
- at least one semiconductor chip (5), configured to process high frequency RF signals;
- at least one on-chip protective layer (6), configured to be located on the semiconductor chip (5) and to physically protect the upper part of the semiconductor chip (5);
- at least one connection layer (7), configured to establish electrical, thermal and physical connection between the semiconductor chip (5) and the QFN packaging base;
- at least one conductive back surface layer (8), configured to establish electrical, and thermal connection between the semiconductor chip (5) and the QFN packaging base;
- multiple direct contact connections (9), configured to connect the semiconductor chip (5) to QFN side connections (3) and at least one QFN base connection (4).

2. The chip-scale QFN plastic packaging system (1) according to claim 1, **characterized in that**; the QFN side connections (3) configured to connect to the semiconductor chip (5) with at least one direct contact connection (9).

3. The chip-scale QFN plastic packaging system (1) according to claim 1 or 2, **characterized in that**; the QFN base connection (4) configured to connect to the semiconductor chip (5) with at least one direct contact connection (9).

4. The chip-scale QFN plastic packaging system (1) according to any of the preceding claims, **characterized in that**; the semiconductor chip (5) configured to connect to multiple QFN side connections (3) and at least one QFN base connection (4) with multiple direct contact connections (9).

5. The chip-scale QFN plastic packaging system (1) according to any of the preceding claims, **characterized in that**; the connection layer (7) configured to be produced from materials with a thermal expansion coefficient that will dampen the thermal expansion coefficient difference between the semiconductor chip (5) and the QFN packaging base.

6. The chip-scale QFN plastic packaging system (1) according to any of the preceding claims, **characterized in that**; the conductive back surface layer (8) configured to mechanically support the electrical connection of the direct contact connections (9) of the semiconductor chip (5)

7. The chip-scale QFN plastic packaging system (1) according to any of the preceding claims, **characterized in that**; the conductive back surface layer (8) configured to facilitate the thermal energy dissipation of the semiconductor chip (5) in combination with the connection layer (7).

8. The chip-scale QFN plastic packaging system (1) according to any of the preceding claims, **characterized in that**; direct contact connections (9) configured to connect the semiconductor chip (5) to QFN side connections (3) and at least one QFN base connection (4) by creating an interface with the conductive back surface layer (8) and the connection layer (7).
